Europäisches Patentamt

European Patent Office

Office européen des brevets

(11) Veröffentlichungsnummer: **0 382 046**
**A2**

(12) **EUROPÄISCHE PATENTANMELDUNG**

(21) Anmeldenummer: **90101765.7**

(22) Anmeldetag: **30.01.90**

(51) Int. Cl.5: **G03F 7/027, G03F 7/032**

(30) Priorität: **06.02.89 DE 3903421**

(43) Veröffentlichungstag der Anmeldung:
**16.08.90 Patentblatt 90/33**

(84) Benannte Vertragsstaaten:
**AT BE CH DE FR GB IT LI NL SE**

(71) Anmelder: **HOECHST AKTIENGESELLSCHAFT**
**Postfach 80 03 20**
**D-6230 Frankfurt am Main 80(DE)**

(72) Erfinder: **Kämpf, Günther, Dr.**
**Rehangstrasse 3**
**D-6227 Oestrich-Winkel(DE)**
Erfinder: **Feldhues, Michael, Dr.**
**Im Weiber 18**
**D-6332 Bad Soden-Neuenhain(DE)**
Erfinder: **Scheunemann, Ude, Dr.**
**Feldbergstrasse 12**
**D-6237 Liederbach(DE)**
Erfinder: **Lingnau, Jürgen, Dr.**
**Karolingerstrasse 10**
**D-6500 Mainz-Laubenheim(DE)**
Erfinder: **Dammel, Ralph, Dr.**
**Eibenweg 39**
**D-6500 Mainz-Bretzenheim(DE)**

(54) **Elektrisch leitfähige Resistmasse, Verfahren zu ihrer Herstellung und ihre Verwendung.**

(57) Übliche, gegenüber ionisierender Strahlung empfindliche Polymere, die zur Herstellung von Resists verwendet werden, rufen bei der Bestrahlung elektrostatische Aufladungen und damit Felder hervor, die sich durch die erfindungsgemäße Resistmasse vermeiden lassen. Dabei wird dem Polymer ein lösliches, elektrisch leitfähiges Oligomer oder Polymer zugesetzt.

Fig. 2

Fig. 1

EP 0 382 046 A2

## Elektrisch leitfähige Resistmasse, Verfahren zu ihrer Herstellung und ihre Verwendung

Die Erfindung bezieht sich auf eine elektrisch leitfähige Resistmasse, welche elektrostatische Aufladungen und die daraus resultierenden Felder verhindern kann, ein Verfahren zu ihrer Herstellung und ihre Verwendung, insbesondere zur Herstellung von Elektronenstrahlresists.

Es ist bekannt, daß insbesondere bei Elektronenstrahlbelichtung zur Erzeugung sehr feiner Resiststrukturen im Submikronbereich auf nichtleitenden Substraten wie Glas, Quarz, Lithiumniobat, undotiertem Silizium, Germanium oder III-V-Halbleitern durch Sekundärelektronen elektrische Felder entstehen, die den Primärstrahl ablenken, so daß die Bildwiedergabe mangelhaft ist (vgl. Appl. Phys. Lett. 48(13), 835 (1986)). Entsprechende auflösungsbegrenzende Effekte werden auch beim Einsatz der Rasterelektronenmikroskopie zur Inspektion und Metrologie von integrierten Schaltkreisen beobachtet.

Zur Vermeidung von Aufladungseffekten können beispielsweise verwendet werden: Indiumoxid, Zinnoxid oder ITO-Schichten auf Glassubstraten, auf die dann der Resist appliziert wird (vgl. Chem. Abstr. 102, 229.567n).

Die Verwendung eines Kohlenstoffilms als leitfähige Unterschicht bedingt eine zusätzliche Temperaturbehandlung bis auf 400° C nach der Deposition des Films. Dies führt aber dazu, daß folgende oder bereits durchgeführte Prozeßstufen unbrauchbar werden können (vgl. Appl. Phys. Lett. 48 (13), 835 (1986)).

Durch Applikation einer Lösung aus Ammonium-Polystyrolsulfonat als Top- oder Bottom-Layer können ebenfalls Aufladungseffekte unterdrückt werden (vgl. New Materials/Japan, 9 - (5), 13 (1988)).

Weiterhin ist eine Resistmasse bekannt, die einen leitfähigen polymeren Tetracyanochinondimethan-(TCNQ)-Salzkomplex in einer PMMA-Matrix beinhaltet, um die Aufladungseffekte zu vermeiden. Nachteilig an diesem Verfahren ist, daß TCNQ-Komplexe in der Regel unlöslich oder schwer löslich sind, so daß beim Aufbringen der Resistmasse eine Phasentrennung eintreten kann. Zudem sind TCNQ-Komplexe wegen ihrer Toxizität schwierig zu handhaben und zersetzen sich schon bei erhöhter Temperatur (vgl. Chem. Abstr. 108, 29440c).

Es bestand daher die Aufgabe, elektrisch leitfähige Resistmassen bereitzustellen, die die oben genannten Nachteile nicht aufweisen und die zudem mit den üblichen in der Mikroelektronik angewandten Verfahren verarbeitet werden können.

Es wurde gefunden, daß der Zusatz von löslichen elektrisch leitfähigen Oligomeren oder löslichen elektrisch leitfähigen Polymeren zu üblichen, gegenüber ionisierender Strahlung empfindlichen Resistformulierungen die zur Vermeidung von Aufladungseffekten erforderliche Leitfähigkeit beiträgt, ohne daß die bei der Strukturierung notwendigen Verarbeitungsschritte grundlegend zu verändern wären.

Die Erfindung betrifft somit eine elektrisch leitfähige Resistmasse, im wesentlichen bestehend aus mindestens einem gegenüber ionisierender Strahlung empfindlichen Polymer und einem löslichen, elektrisch leitfähigen Oligomeren oder einem löslichen, elektrisch leitfähigen Polymeren.

Die Erfindung betrifft weiterhin ein Verfahren zur Herstellung einer elektrisch leitfähigen Resistmasse, dadurch gekennzeichnet, daß mindestens einem gegenüber ionisierender Strahlung empfindlichen Polymer ein in einem geeigneten Lösemittel gelöstes elektrisch leitfähiges Oligomer oder Polymer zugemischt wird.

Zur Herstellung von Elektronenstrahlresists können grundsätzlich alle bekannten Formulierungen verwendet werden. Genannt seien auf Novolak als Bindemittel basierende Formulierungen sowohl des positiv arbeitenden Typs als auch des negativ arbeitenden Typs. Es eignen sich aber auch Formulierungen aus Polymeren, die durch hochenergetische Strahlung vernetzbar oder abbaubar sind. Aufgrund ihrer geringeren Wasseraufnahme zeigen insbesondere derartige in einem Lösemittel zu entwickelnde Resists besonders gravierende Aufladungseffekte, die sich durch die Zugabe von löslichen, elektrisch leitfähigen Oligomeren oder Polymeren verhindern lassen. Beispiele sind gegebenenfalls halogenierte Polyacrylate, Polymethacrylate, Polyolefinsulfone, gegebenenfalls in Kombination mit einem anderen Bindemittel, oder chlorierte oder chlormethylierte Polystyrole sowie deren Copolymere oder epoxidierte Polybutadiene.

Als leitfähige Oligomere oder leitfähige Polymere können grundsätzlich Verbindungen eingesetzt werden, deren Löslichkeit in den bei den Resistformulierungen eingesetzten Lösemitteln hinreichend hoch ist. Dazu gehören Oligo- und Polythiophenderivate, die zusätzlich in 3-Stellung Substituenten tragen. Bevorzugt werden 3-Alkoxy-substituierte Oligo- und Polythiophene eingesetzt. Beispiele sind 3-Butylthiophen, 3-Pentylthiophen, 3-Hexylthiophen, 3-Octylthiophen, 3-Dodecylthiophen, 3-(Methoxyethoxyethoxymethyl)-thiophen, 3,4-Diethylthiophen, 3-Butyl-4-methylthiophen, 3-Methoxythiophen, 3-Ethoxythiophen, 3-Propoxythiophen, 3-(Methoxyethoxy)thiophen, 3-Methoxy-4-methylthiophen, 3-Ethyl-4-methoxythiophen, 3-Butyl-4-methoxythiophen, 3-Ethoxy-4-methylthiophen, 3-Ethoxy-4-ethylthiophen, 3-Butoxy-4-methylthiophen, 3,4-Dimethoxythiophen, 3-Ethoxy-4-methoxythiophen oder 3-Butoxy-4-methylthiophen.

Besonders gute Eigenschaften (z.B. besonders hohe Löslichkeiten) werden dann erreicht, wenn die Alkoxy-Gruppe mindestens 6 C-Atome, vorzugsweise 6 bis 25 C-Atome, umfaßt, wie bei 3-Hexyloxythiophen, 3-Heptyloxythiophen, 3-Octyloxythiophen, 3-Nonyloxythiophen, 3-Decyl oxythiophen, 3-Undecyloxythiophen, 3-Dodecyloxythiophen, 3-Tetradecyloxythiophen, 3-Pentadecyloxythiophen, 3-Hexadecyloxythiophen, 3-Octadecyloxythiophen, 3-Eicosyloxythiophen, 3-Docosyloxythiophen, 3-(2′-Ethylhexyloxy)thiophen, 3-(2′,4′,4′-Trimethylpentyloxy)thiophen, 3,4-Dihexyloxythiophen, 3,4-Dioctyloxythiophen, 3,4-Dinonyloxythiophen, 3,4-Didodecyloxythiophen, 3-Methoxy-4-pentyloxythiophen, 3-Hexyloxy-4-methoxythiophen, 3-Methoxy-4-nonyloxythiophen, 3-Dodecyloxy-4-methoxythiophen, 3-Docosyl-4-methoxythiophen, 3-Ethoxy-4-pentyloxythiophen, 3-Ethoxy-4-hexyloxythiophen, 3-Butoxy-4-dodecyloxythiophen oder 3-(2′-Ethylhexyloxy)-4-methoxythiophen.

Je nach der Leitfähigkeit des in der Masse vorhandenen Oligomers oder Polymers sowie nach der Grundleitfähigkeit der Formulierung erweist sich der Zusatz von 0,01 bis 10 Gew.-% des leitfähigen Oligomers oder Polymers zur Trockensubstanz der Formulierung als günstig, die bevorzugten Konzentrationen liegen zwischen 0,1 und 5 Gew.-%, insbesondere zwischen 0,1 und 3 Gew.-%.

Als Lösemittel finden solche Anwendung, die sowohl die Komponenten der Formulierung als auch das leitfähige Oligomere oder leitfähige Polymere lösen. Eingesetzt werden können Glykolether, beispielsweise Glykolmonomethylether, Glykoldimethylether, Glykolmonoethylether oder Propylenglykolmonoalkylether, vorzugsweise Propylenglykolmethylether, aliphatische Ester, beispielsweise Ethylacetat, Hydroxyethylacetat, Alkoxyethyl acetat, n-Butylacetat, Propylenglykolmonoalkyletheracetat, vorzugsweise Propylenglykolmethyletheracetat oder Amylacetat, Ether, beispielsweise Dioxan oder Tetrahydrofuran, Ketone, beispielsweise Methylethylketon, Methylisobutylketon, Cyclopentanon und Cyclohexanon, Dimethylformamid, Dimethylacetamid, Hexamethylphosphorsäureamid, N-Methylpyrrolidon, Butyrolacton, Aromaten, wie Toluol, Chlorbenzol, Xylole, und Gemische der genannten Lösemittel, gegebenenfalls auch mit Nichtlösern. Bei Einhaltung entsprechender Sicherheitsmaßnahmen und Vorkehrung für eine entsprechende Entsorgung kann die Beschichtung auch aus anderen Lösemitteln, beispielsweise Acetonitril, Methoxypropionitril, Cyanessigsäuremethylester oder deren Gemische, erfolgen.

Die Anwendung der erfindungsgemäßen leitfähigen Resistmasse ist nicht auf isolierende Substrate beschränkt. Der besondere Vorteil kommt aber nur bei der Applikation auf hochisolierenden Substraten zur Geltung. Als solche lassen sich einsetzen: undotierte Halbleitersubstrate, wie Si, Ge oder GaAs mit einer geringen Oberfläche oder Volumenleitfähigkeit, Substrate mit hochisolierenden Beschichtungen organischer oder anorganischer Art, wie Oxidschichten, Quarz, Lithiumniobat, Strontiumtitanat, Saphir, Diamant, aber auch isolierende Folien aus organischen Polymeren, wie Polyethylenterephthalat oder Folien aus anorganischen Materialien, wie Membranen aus Silizium, Siliziumcarbid oder Beryllium.

Zur Verbesserung der Haftung auf dem Substrat kann der Resistmasse ein Haftvermittler zugesetzt werden. Ein Haftvermittler kann aber auch vor der Beschichtung auf dem Substrat appliziert werden.

Ferner können den erfindungsgemäßen strahlungsempfindlichen Gemischen gegebenenfalls Farbstoffe, Pigmente, Weichmacher, Netzmittel und Verlaufmittel, beispielsweise Polyglykole, Celluloseether, vorzugsweise Ethylcellulose, zur Verbesserung spezieller Erfordernisse wie Flexibilität, Haftung und Glanz zugesetzt werden.

Die Herstellung der erfindungsgemäßen Resistmasse kann so erfolgen, daß das elektrisch leitfähige Oligomere oder elektrisch leitfähige Polymere in einem geeigneten Lösemittel zunächst gelöst und dann einer fertigen Resistformulierung zugegeben oder getrennt von dieser aufgetragen wird. Die leitfähige Verbindung kann aber auch mit den Einzelkomponenten der Resistformulierung zusammen in einem geeigneten Lösemittel oder Lösemittelgemisch gelöst werden. Dies geschieht bei einer Temperatur zwischen Schmelz- und Siedepunkt des eingesetzten Lösemittels oder Lösemittelgemisches, vorzugsweise im Bereich von 0 °C und 80 °C, insbesondere von 20 °C und 60 °C, gegebenenfalls unter Rühren oder anderen Mischtechniken. Die Konzentration der Hauptkomponenten in der Lösung beträgt 0,1 bis 30, vorzugsweise 0,5 bis 10 Gew.-%.

Die Resistmasse kann nach den üblichen Methoden verarbeitet werden, wie Spin-Coating oder Sprühbeschichtung.

Durch die Wahl der Beschichtungsparameter und den Feststoffgehalt der Lösung kann die Schichtdicke in weiten Grenzen je nach Bedarf eingestellt werden.

Die Trocknung erfolgt je nach Substrat und Anwendung z.B. in einem Ofen, auf einer Hot Plate oder, bei bahnweiser Verarbeitung, im Trockenkanal bei erhöhter Temperatur, vorzugsweise zwischen 80° und 130°C. Vor der Trocknung bei erhöhter Temperatur kann ein Vortrocknungsschritt bei Raumtemperatur angewandt werden.

Die Bestrahlung erfolgt mit ionisierender Strahlung, beispielsweise mit Elektronenstrahlung oder Röntgenstrahlung, vorzugsweise mit Elektronenstrahlung.

Grundsätzlich ist auch die Strukturierung derartiger Resists mit UV-Licht möglich.

Die Entwicklung nach der Belichtung erfolgt mit den für die jeweiligen Resistformulierungen üblichen Entwicklern. Dieses sind überwiegend Entwickler, die im wesentlichen aus organischen Lösemitteln bestehen. Im Falle von Resistformulierungen, die alkalilösliche oder wasserlösliche Bindemittel enthalten, können auch wäßrige oder wäßrigalkalische Entwickler eingesetzt werden.

Eine Erhöhung der Ätzresistenz wird in den folgenden Prozeßschritten dadurch ermöglicht, daß die entwickelten Resistschichten noch einige Zeit, z. B. 5 bis 40 Minuten, bei erhöhter Temperatur, gegebenenfalls unter gleichzeitiger Einwirkung von UV-Licht, gehalten werden.

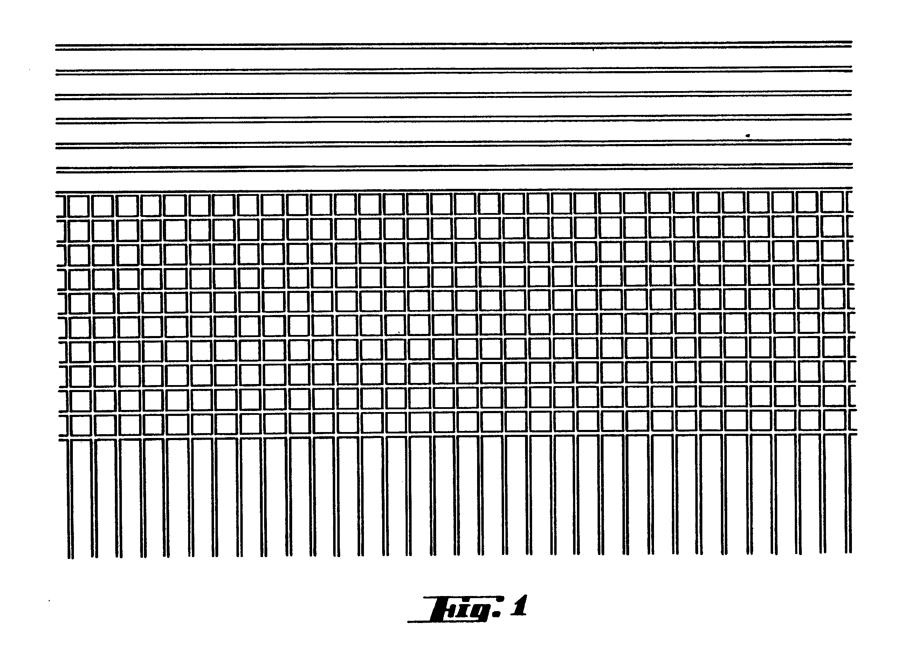

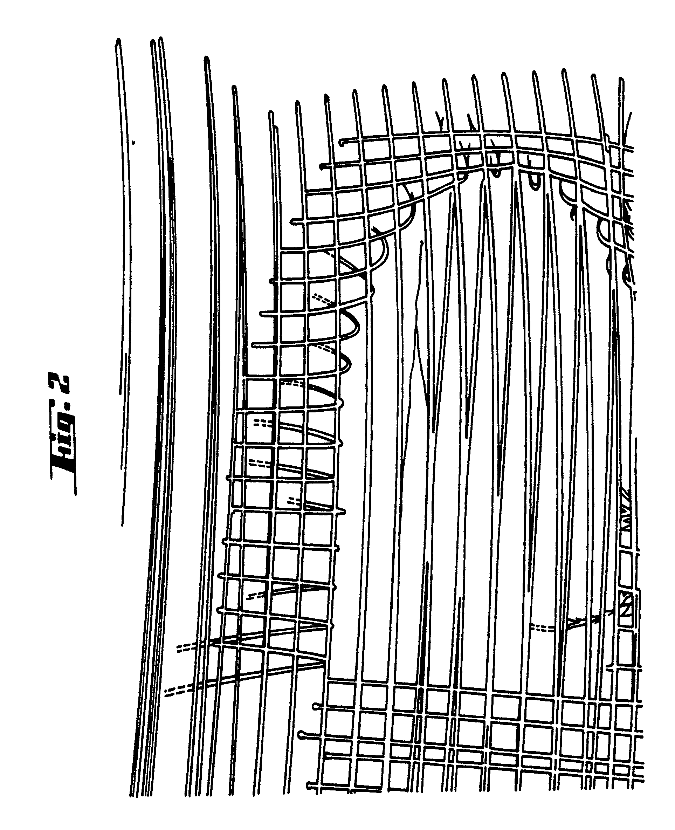

Bei einem hinreichend leitfähigen Substrat wird nach der Entwicklung ein Muster erhalten, das in Figur 1 dargestellt wird. Treten dagegen Aufladungseffekte auf, so erhält man die in Figur 2 wiedergegebenen Strukturen.

Die erfindungsgemäße Resistmasse findet Anwendung bei der Herstellung von Elektronenstrahlresists zur Verhinderung von elektrostatischen Aufladungen und den daraus resultierenden Feldern.

Die folgenden Beispiele sollen die Erfindung weiter erläutern.

Vergleichsbeispiel A

1 g Polymethylmethacrylat (PMMA) wurde in 100 ml Tetrahydrofuran gelöst und bei 1000 U/min auf einem Spin-Coater auf einen p-dotierten Si-Wafer aufgebracht. Nach dem Trocknen bei 100° C innerhalb 1 min (Hot Plate) resultierte eine Schichtdicke von 400 nm. Die Bestrahlung erfolgte mit 100 $\mu$C/cm$^2$ bei einer Beschleunigungsspannung von 25 kV. Anschließend wurde 40 s in einem Entwickler, bestehend aus Methylethylketon/Isopropanol (Volumenverhältnis 1 : 4), bei 21° C entwickelt. Auf diesem hinreichend leitfähigen Substrat wurde das in Fig. 1 wiedergegebene Muster erhalten, das dem vorgegebenen Muster entsprach.

Vergleichsbeispiel B

Vergleichsbeispiel A wurde wiederholt mit der Maßgabe, daß anstelle des leitfähigen Substrats ein isolierendes Substrat (Quarz) verwendet wurde. Bei gleicher Vorgehensweise war es aber nicht möglich, das vorgegebene Muster (analog Fig. 1) in den Resist zu übertragen. Bedingt durch Aufladungseffekte wurden die in Fig. 2 wiedergegebenen Strukturen beobachtet.

Beispiel 1 (Herstellung von Polydodecyloxythiophen)

4,34 g Tetraethylammoniumtetrafluoroborat, 5,36 g 3-Dodecyloxythiophen und 200 g Acetonitril wurden in eine ungeteilte Elektrolysezelle mit Kühlmantel gegeben. Die Kathode bestand aus einem Edelstahl-Blech von 60 mm Länge und 55 mm Breite. Als Anode wurde ein Platin-Blech von 60 mm Länge und 55 mm Breite eingesetzt. Bei einer Elektrolysetemperatur von 20° C und einem Anodenstrom von 50 mA erhielt man eine Zellenspannung von 3 bis 6 Volt. Nach Verbrauch eines Viertels der theoretisch benötigten Strommenge wurde das auf der Anode abgeschiedene Polymere mechanisch abgetrennt und die Anode erneut eingesetzt. Dieses Verfahren wurde bis zum Verbrauch der theoretisch benötigten Strommenge wiederholt. Das gesammelte Rohprodukt wurde mechanisch zerkleinert, mit Wasser gewaschen, getrocknet, mit Pentan und Acetonitril gewaschen und erneut getrocknet. Das Produkt wurde in Tetrahydrofuran aufgenommen, über einen Glasfiltertiegel der Porengröße G3 filtriert und das Filtrat im Rotationsverdampfer zur Trockene eingeengt. Es wurden 1,88 g eines blauschwarz glänzenden Feststoffs erhalten. Die Elementaranalyse lieferte folgende Werte: 65,7 % C, 9,0 % H, 11,1 % S, 5,3 % F. Ein Pulverpreßling des gemahlenen Produkts besaß eine spezifische Leitfähigkeit von 1,5 10$^{-2}$ S/cm. Bei der DTG wurde bis 255° C ein Gewichtsverlust von weniger als 10 % beobachtet. Die DSC zeigte ein Maximum bei 350° C (130 J/g). Die GPC der undotierten Form ergab eine mittlere Molmasse von ca. 5400.

0,196 g Polymethylmethacrylat und 0,04 g Polydodecyloxythiophen, hergestellt gemäß Beispiel 1, wurden in 20 ml Tetrahydrofuran gelöst und auf p-dotiertem Silizium gemäß Vergleichsbeispiel A appliziert. Die Schichtdicke betrug 380 nm, die spezifische Leitfähigkeit 1 10$^{-8}$ S/cm. Die Bestrahlung erfolgte ebenfalls mit 100 $\mu$C/cm$^2$ bei 50 kV. Nach der Entwicklung innerhalb 40 s in dem in Vergleichsbeispiel A geschilderten Entwickler wurde eine Strukturübertragung wie in Fig. 1 erzielt.

Beispiel 2

Die Resistmasse aus Beispiel 1 wurde gemäß Vergleichsbeispiel B auf ein isolierendes Quarzsubstrat aufgetragen. Nach Bestrahlung und Entwicklung wie in Vergleichsbeispiel A wurde eine gute Strukturübertragung ohne Verzerrungen entsprechend Fig. 1 erhalten.

Beispiel 3

Beispiel 2 wurde wiederholt mit der Maßgabe, daß der Anteil des Polydodecyloxythiophens auf 5 Gew.-% der Festsubstanz erhöht wurde. Die erhaltene spezifische Leitfähigkeit betrug $4,3 \cdot 10^{-7}$ S/cm. Das Resultat entsprach Fig. 2.

Beispiel 4 (Herstellung von Polymethoxythiophen)

4,34 g Tetraethylammoniumtetrafluoroborat, 4,56 g 3-Methoxythiophen und 250 g Acetonitril wurden in eine ungeteilte Elektrolysezelle mit Kühlmantel gegeben. Die Kathode bestand aus Edelstahl-Blechen von 80 mm Länge und 55 mm Breite. Als Anode wurde ein Kohlenstoff-Filz (Flächengewicht ca. 0,3 $kg/m^2$, spez. Oberfläche (BET) ca. 1,5 $m^2/g$), von 80 mm Länge, 55 mm Breite und 3 mm Dicke eingesetzt (beidseitige geometrische Fläche ca. 90 $cm^2$). Die Anode wurde in einem Abstand von 2 cm parallel zur Kathode befestigt und getrennt über einen Abstandshalter aus Polypropylen-Netz. Bei einer Elektrolysetemperatur von 20°C und einem Anodenstrom von 400 mA erhielt man eine Zellenspannung von 5 bis 11 Volt. Nach Verbrauch der Hälfte der theoretisch benötigten Strommenge wurde die mit den Oligomeren beladene Anode gegen eine neue ausgetauscht und nach Verbrauch der theoretischen Strommenge wurde die Elektrolyse beendet. Die mit dem Rohprodukt beladenen Anoden wurden jeweils sofort nach dem Austausch getrocknet und in ein Bad mit Methylenchlorid gestellt und dort mehrfach längere Zeit digeriert. Nach dem erneuten Trocknen wurden die mit den Oligomeren beladenen Kohlenstoff-Filze in einem Bad mit Acetonitril so lange digeriert, bis die Oligomeren praktisch vollständig in Lösung gegangen waren. Die tief dunkelblaue Lösung wurde im Rotationsverdampfer zur Trockene eingeengt. Das Rohprodukt wurde mechanisch zerkleinert, mit Wasser gewaschen, getrocknet, 12 h mit Methylenchlorid digeriert, anschließend abfiltriert und getrocknet. Zur weiteren Reinigung wurde das erhaltene Material erneut in Acetonitril gelöst und 0,5 h bei 10 000 U/min zentrifugiert und das Zentrifugat im Rotationsverdampfer zur Trockene eingeengt. Es wurden 1,92 g eines bronzemetallisch glänzenden Feststoffs erhalten. Die Elementaranalyse lieferte folgende Werte: 44,5 % C, 3,2 % H, 22,1 % S, 9,4 % F. Ein Pulverpreßling des gemahlenen Produkts besaß eine spezifische Leitfähigkeit von $1,8 \cdot 10^{-3}$ S/cm. Bei der DTG wurde bis 245°C ein Gewichtsverlust von weniger als 10 % beobachtet. Die DSC zeigte ein Maximum bei 325°C. Im Massenspektrum der undotierten Form wurden die Molekülionen des Pentameren (m/e = 562) und Hexameren (m/e = 674) nachgewiesen. Die GPC der undotierten Form ergab, daß mehr als 80 % des Produkts aus Pentameren und Hexameren bestanden. Im UV/VIS/NIR-Spektrum in Tetrahydrofuran zeigte das undotierte Pentamere ein Maximum bei $\lambda = 460$ nm, das undotierte Hexamere ein Maximum bei $\lambda = 486$ nm.

Eine Lösung aus 0.02 g Polymethoxythiophen und 0.98 g PMMA in einem Lösemittelgemisch aus 7 ml Acetonitril und 3 ml Tetrahydrofuran wurde auf ein isolierendes Substrat appliziert. Nach der Bestrahlung mit 100 $\mu C/cm^2$ bei 25 kV wurde in Methylethylketon/Isopropanol (1 : 4) während 60 s entwickelt. Die erhaltenen Strukturen entsprachen denen in Fig. 1.

**Ansprüche**

1. Elektrisch leitfähige Resistmasse, im wesentlichen bestehend aus mindestens einem gegenüber ionisierender Strahlung empfindlichen Polymer und einem löslichen, elektrisch leitfähigen Oligomeren oder einem löslichen, elektrisch leitfähigen Polymeren.

2. Resistmasse nach Anspruch 1, dadurch gekennzeichnet, daß die Resistmasse 0,01 bis 10 Gew.-% des leitfähigen Oligomers oder Polymers, bezogen auf die Trockensubstanz der Resistformulierung, enthält.

3. Resistmasse nach Anspruch 1, dadurch gekennzeichnet, daß als lösliches, elektrisch leitfähiges Oligomer oder lösliches, elektrisch leitfähiges Polymer ein 3-substituiertes Polythiophen verwendet wird.

4. Resistmasse nach Anspruch 1, dadurch gekennzeichnet, daß das leitfähige Oligomer oder Polymer von der Resistschicht getrennt aufgetragen wird.

5. Resistmasse nach Anspruch 1, dadurch gekennzeichnet, daß ein auf einem alkalilöslichen Bindemittel basierende Resistformulierung verwendet wird.

6. Resistmasse nach Anspruch 1, dadurch gekennzeichnet, daß zur Herstellung einer in einem Lösemittel entwickelbaren Resistmasse mindestens ein durch hochenergetische Strahlung vernetzbares und abbaubares Polymer verwendet wird.

7. Verfahren zur Herstellung einer elektrisch leitfähigen Resistmasse gemäß Anspruch 1, dadurch gekennzeichnet, daß mindestens einem gegenüber ionisierender Strahlung empfindlichen Polymer ein in einem geeigneten Lösemittel gelöstes elektrisch leitfähiges Oligomer oder Polymer zugemischt wird.

8. Verwendung einer elektrisch leitfähigen Resistmasse gemäß Anspruch 1 bei der Herstellung von Elektronenstrahlresists zur Verhinderung von elektrostatischen Aufladungen und der daraus resultierenden Felder.

Fig. 1

Fig. 2

EP 0 382 046 A2